(19) Europäisches Patentamt / European Patent Office / Office européen des brevets

(11) **EP 2 363 818 A2**

(12) **DEMANDE DE BREVET EUROPEEN**

(43) Date de publication:
**07.09.2011 Bulletin 2011/36**

(51) Int Cl.:
**G06F 17/50** (2006.01)

(21) Numéro de dépôt: **10184205.2**

(22) Date de dépôt: **09.01.2003**

(84) Etats contractants désignés:
**DE FR GB IT**

(30) Priorité: **09.01.2002 FR 0200217**

(62) Numéro(s) de document de la (des) demande(s)
initiale(s) en application de l'article 76 CBE:
**03290052.4 / 1 327 944**

(71) Demandeur: **STMicroelectronics S.A.**
**92120 Montrouge (FR)**

(72) Inventeur: **Bianchi, Raul Andrès**
**38000 Grenoble (FR)**

(74) Mandataire: **Dossmann, Gérard**
**Casalonga & Partners**
**Bayerstrasse 71-73**
**80335 München (DE)**

Remarques:
Cette demande a été déposée le 30-09-2010 comme demande divisionnaire de la demande mentionnée sous le code INID 62.

(54) **Procédé et dispositif de modélisation d'un circuit intégré comportant au moins un transistor à effet de champ à grille isolée, procédé de réalisation circuit intégré correspondant et circuit intégré correspondant**

(57) Le dispositif de modélisation comprend des moyens d'élaboration (MLB) aptes à élaborer un paramètre représentatif des contraintes mécaniques appliquées sur la zone active du transistor, et des moyens de traitement (MT) aptes à déterminer certains au moins des paramètres électriques (P) du transistor en prenant en compte ce paramètre de contrainte.

FIG.1

EP 2 363 818 A2

**Description**

L'invention concerne les circuits intégrés, et notamment leur modélisation, en particulier celle des transistors à effet de champ à grilles isolées (transistors MOSFET).

Actuellement, il existe de nombreux modèles de simulation pour des transistors MOSFET, comme par exemple le modèle BSIM3v3.2, disponible auprès du Department of Electrical Engineering and Computer Sciences, de l'Université de Berkeley, Californie, et décrit notamment dans le manuel utilisateur de 1997-1998 de Weidong Liu et autres.

Un tel modèle est utilisé par les concepteurs de circuits intégrés pour définir et simuler les transistors MOSFET quant à leurs caractéristiques électriques souhaitées, telles que par exemple la mobilité des porteurs, la tension de seuil, le courant de drain, ....

Or, il s'avère, dans certains cas, que les performances simulées à l'aide de ces modèles de simulation ne correspondent pas aux performances réelles attendues pour le transistor MOSFET finalement réalisé.

L'invention vise à apporter une solution à ce problème.

Un but de l'invention est de proposer une meilleure approche dans la modélisation des transistors, de sorte que les performances réelles du transistor finalement réalisé soient plus proches des performances simulées à l'aide du modèle de simulation.

L'invention a encore pour but de permettre la réalisation de circuits intégrés comportant des transistors MOSFET dont les performances électriques, notamment en terme de mobilité, peuvent être ajustées et améliorées en fonction des applications souhaitées.

L'invention part de l'observation que certains paramètres électriques d'un transistor, comme par exemple la mobilité, la tension de seuil ou encore la résistance drain/source, varient en fonction des contraintes mécaniques appliquées sur le canal du transistor. Ces contraintes mécaniques résultent du procédé de fabrication, notamment lors de la formation des régions électriquement isolantes (du type par exemple tranchée peu profonde (STI : « shallow trench isolation »)) délimitant la zone active du transistor.

L'invention propose donc un procédé de modélisation d'un circuit intégré comportant au moins un transistor à effet de champ à grille isolée, dans lequel on élabore un paramètre représentatif des contraintes mécaniques appliquées sur la zone active du transistor, et on prend en compte ce paramètre de contrainte pour la détermination de certains au moins des paramètres électriques du transistor, comme par exemple la mobilité des porteurs, la tension de seuil, la résistance d'accès drain/source, ....

Dans certains cas simples, le procédé selon l'invention permettrait de modéliser directement certains paramètres électriques en prenant en compte le paramètre de contrainte.

Cependant, en général, l'invention permet avantageusement de compléter des modèles de simulation existants, standards ou non, en corrigeant par exemple certains paramètres d'entrée de ces modèles existants qui vont être utilisés au sein de ces modèles existants pour la détermination de paramètres électriques plus élaborés des transistors.

Ainsi, par exemple, la mobilité $\mu 0$ des porteurs à faible champ et à température ambiante est un paramètre qui va être directement corrigé par le procédé selon l'invention pour tenir compte des contraintes mécaniques. Et, une fois corrigé, ce paramètre $\mu 0$ va être injecté dans un modèle existant, par exemple le modèle BSIM3v3.2 précité, et utilisé pour déterminer la mobilité effective $\mu_{eff}$ des porteurs, qui est un paramètre plus élaboré qui prend notamment en compte des effets secondaires dans le comportement électrique du transistor.

Mais quoi qu'il en soit, au final, ce paramètre électrique $\mu_{eff}$ aura bien été déterminé en prenant en compte l'effet des contraintes mécaniques sur la zone active du transistor.

De même, la résistance parasite drain/source par unité de largeur du canal Rdsw est un paramètre qui est aisément déterminable par le procédé selon l'invention en tenant compte des contraintes mécaniques, et qui sera ensuite injecté dans un modèle existant pour déterminer la résistance drain/source Rds.

Il en est de même par exemple pour les paramètres

Vth0 : tension de seuil à tension grille/source nulle et pour une grande largeur de canal,
K1 : coefficient d'effet substrat (body effect) du 1er ordre,
K2 : coefficient d'effet substrat du 2ème ordre,
K3 : coefficient de largeur de canal étroite,
K3b : coefficient d'effet substrat de K3,
Dvt0 : premier coefficient d'effet canal court sur la tension de seuil,
Dvt0w : premier coefficient d'effet canal court sur la tension de seuil pour une faible longueur de canal,
Eta0 : coefficient DIBL (Drain-Induced Barrier Lowering) dans la région sous-seuil (subthreshold region),
Etab : coefficient de polarisation substrat ( body-bias) pour l'effet DIBL dans la région sous-seuil,

qui une fois déterminés par le procédé selon l'invention en tenant compte des contraintes mécaniques, seront injectés dans le modèle BSIM3v3.2 pour déterminer la tension de seuil Vth.

Selon un mode de mise en oeuvre de l'invention, on définit à partir de la zone active du transistor, une zone active dite « utile » qui est égale à une partie ou à la totalité de la zone active du transistor. Cette zone active dite « utile » peut être, comme on le verra plus en détail ci-après, par exemple la partie de la zone active contenue dans un rectangle dont la dimension latérale comptée dans le sens de la largeur du canal, est égale à la largeur du canal, et dont chaque bord s'étendant dans le sens de la largeur du canal est séparé du flanc correspondant de la grille d'une distance limite prédéterminée, qui peut être de l'ordre de dix fois une distance minimale requise pour une prise de contact sur la zone active.

Le paramètre de contrainte est alors de préférence un paramètre géométrique $a_{eq}$ représentatif d'une distance, comptée dans le sens de la longueur du canal du transistor, séparant la grille du transistor du bord de la zone active utile.

Ainsi, l'invention est ici remarquable en ce sens qu'un paramètre géométrique extrêmement simple et unidimensionnel, en l'espèce une distance, permet de prendre en compte l'effet des contraintes mécaniques tridimensionnelles, sur les paramètres électriques du transistor.

Lorsque la zone active utile du transistor est rectangulaire et que la grille est centrée sur la zone active utile, de façon à définir des régions de source et de drain géométriquement identiques, on peut alors élaborer le paramètre de contrainte $a_{eq}$ comme étant la distance comptée dans le sens de la longueur du canal, séparant un flanc de la grille du bord correspondant de la région de source ou de drain.

Ceci étant, les transistors ne présentent pas toujours des zones actives rectangulaires et des grilles centrées sur ces zones actives. Aussi, lorsque la région active utile du transistor comporte des régions de source et de drain géométriquement différentes, on élabore alors avantageusement un premier paramètre géométrique $a_s$ représentatif d'une première distance comptée dans le sens de la longueur du canal, séparant la grille et le bord de la région de source.

On élabore également un deuxième paramètre géométrique $a_d$ représentatif d'une distance comptée dans le sens de la longueur du canal, séparant la grille et le bord de la région de drain.

On élabore alors le paramètre de contrainte $a_{eq}$ à partir d'une relation entre le premier paramètre géométrique et le deuxième paramètre géométrique.

Ainsi, par exemple, le paramètre de contrainte $a_{eq}$ peut être pris égal à $1/(1/2a_s + 1/2a_d)$.

Lorsque la zone active utile du transistor comporte au moins une région de source ou de drain dont chaque côté latéral est exempt d'angles ouverts, et qu'il est possible de décomposer ladite région de source et de drain en n régions élémentaires rectangulaires, n étant supérieur ou égal à 1, on définit chaque région élémentaire par une largeur élémentaire $W_i$, et par une distance élémentaire $a_i$, comptée dans le sens de la longueur du canal, et séparant de la grille un bord élémentaire de ladite région élémentaire.

Le paramètre géométrique correspondant $a_s$ ou $a_d$ peut alors être égal à $W/\sum_{i=1}^{n} W_i / a_i$ , où W désigne la largeur du canal du transistor.

Par contre, lorsque ladite zone active utile du transistor comporte au moins une région de source ou de drain dont au moins un côté latéral possède au moins un angle ouvert, on pourra alors considérer que le paramètre correspondant $a_s$ ou $a_d$ est égal à l'infini.

De même, pour des raisons de simplification, si une distance élémentaire $a_i$ d'une région élémentaire de la zone active utile est égale à la distance limite délimitant le rectangle de la zone active utile, on considère alors que cette distance élémentaire $a_i$ est égale par exemple à l'infini.

Selon un mode de mise en oeuvre de l'invention, la détermination d'un paramètre électrique considéré P du transistor est effectuée à partir d'une relation faisant intervenir :

- la valeur de ce paramètre électrique déterminée pour une distance minimale requise de la zone active,
- la valeur du paramètre de contrainte du transistor,
- la valeur de ladite distance minimale requise, et
- un coefficient associé audit paramètre électrique et dépendant de la largeur et de la longueur du canal du transistor.

Lorsque le paramètre de contrainte est un paramètre géométrique $a_{eq}$, le paramètre électrique considéré P est alors défini par exemple par la relation

$$P \; = \; P_{a\min}(\, 1 \; + \; CP_{L,W} \, (1 - a_{\min}/ a_{eq}) \,),$$

dans laquelle $P_{a\min}$ désigne la valeur du paramètre électrique P déterminée pour la distance minimale requise $a_{min}$ de la zone active, et $CP_{L,W}$ désigne ledit coefficient associé au paramètre P.

Dans ce cas, la détermination dudit coefficient $CP_{L,W}$ comporte par exemple les étapes suivantes :

- on réalise plusieurs transistors de référence ayant différentes valeurs de référence Wref, Lref pour la largeur et la longueur de canal, et différentes valeurs pour le paramètre de contrainte,
- on mesure pour chaque transistor de référence réalisé la valeur du paramètre électrique considéré P,
- on détermine pour chaque couple de valeurs Wref, Lref, un coefficient de référence $CP_{Lref,Wref}$ comme étant la pente de la droite d'équation $Y = 1 + CP_{Lref,Wref} X$, dans laquelle $Y = P/P_{a\,min}$ et $X = 1 - a_{min}/a_{eq}$, et
- on détermine le coefficient $CP_{L,W}$ à partir des différents coefficients de référence $CP_{Lref,Wref}$ compte tenu de la largeur W et de la longueur L du canal du transistor, en utilisant éventuellement une interpolation.

L'invention a également pour objet un dispositif de modélisation d'un circuit intégré comportant au moins un transistor à effet de champ à grille isolée.

Selon une caractéristique générale de l'invention, il comprend des moyens d'élaboration aptes à élaborer un paramètre représentatif des contraintes mécaniques appliquées sur la zone active du transistor, et des moyens de traitement aptes à déterminer certains au moins des paramètres électriques du transistor en prenant en compte ce paramètre de contrainte.

Selon un mode de réalisation de l'invention, les moyens d'élaboration sont aptes à définir à partir de la zone active du transistor, une zone active utile égale à une partie ou à la totalité de ladite zone active, et le paramètre de contrainte est un paramètre géométrique $a_{eq}$ représentatif d'une distance, comptée dans le sens de la longueur du canal du transistor, séparant la grille du transistor du bord de la zone active utile.

Selon un mode de réalisation de l'invention, la zone active utile du transistor est rectangulaire et la grille centrée sur la zone active utile de façon à définir des régions de source et de drain géométriquement identiques. Les moyens d'élaboration élaborent alors le paramètre de contrainte $a_{eq}$ comme étant la distance comptée dans le sens de la longueur du canal, séparant un flanc de la grille du bord correspondant de la région de source ou de drain.

Selon un autre mode de réalisation de l'invention, la zone active utile du transistor comporte des régions de source et de drain géométriquement différentes. Les moyens d'élaboration élaborent alors un premier paramètre géométrique $a_s$ représentatif d'une première distance comptée dans le sens de la longueur du canal, séparant la grille et le bord de la région de source, et un deuxième paramètre géométrique $a_d$ représentatif d'une distance comptée dans le sens de la longueur du canal, séparant la grille et le bord de la région de drain. Et les moyens d'élaboration élaborent ledit paramètre de contrainte $a_{eq}$ à partir d'une relation entre le premier paramètre géométrique et le deuxième paramètre géométrique.

Selon un mode de réalisation de l'invention, les moyens de traitement déterminent un paramètre électrique considéré du transistor à partir d'une relation faisant intervenir

- la valeur de ce paramètre électrique déterminée pour une distance minimale requise de la zone active,
- la valeur du paramètre de contrainte du transistor,
- la valeur de ladite distance minimale requise, et
- un coefficient associé audit paramètre électrique et dépendant de la largeur et de la longueur du canal du transistor.

Dans ce cas, le paramètre électrique considéré P peut être défini par la relation $P = P_{a\,min}(1 + CP_{L,W}(1 - a_{min}/a_{eq}))$, dans laquelle $P_{a\,min}$ désigne la valeur du paramètre électrique P déterminée pour la distance minimale requise $a_{min}$ de la zone active, et $CP_{L,W}$ désigne ledit coefficient associé au paramètre P.

Le dispositif de modélisation comporte alors plusieurs transistors de référence ayant différentes valeurs de référence Wref, Lref pour la largeur et la longueur de canal, et différentes valeurs pour le paramètre de contrainte.

Par ailleurs, les moyens de traitement comportent avantageusement

- des moyens de mesure aptes à mesurer pour chaque transistor de référence réalisé la valeur du paramètre électrique considéré P,
- des premiers moyens de calcul aptes à calculer pour chaque couple de valeurs Wref, Lref, un coefficient de référence $CP_{Lref,Wref}$ comme étant la pente de la droite d'équation $Y = 1 + CP_{Lref,Wref} X$, dans laquelle $Y = P/P_{a\,min}$ et $X = 1 - a_{min}/a_{eq}$, et
- des deuxièmes moyens de calcul aptes à calculer le coefficient $CP_{L,W}$ à partir des différents coefficients de référence $CP_{Lref,Wref}$ compte tenu de la largeur W et de la longueur L du canal du transistor, en utilisant éventuellement une interpolation.

L'invention permet également pour la réalisation de transistors, d'ajuster la géométrie de la zone active de ce transistor en fonction d'une valeur désirée pour un paramètre électrique considéré, par exemple la mobilité des porteurs, la tension de seuil, ....

En d'autres termes, avec le procédé de modélisation selon l'invention, on est capable pour un paramètre géométrique de la zone active, de déterminer le paramètre électrique considéré. Par conséquent, à l'inverse, on est capable, pour la réalisation d'un transistor intégré, de déterminer le paramètre géométrique de la zone active du transistor qui va permettre d'obtenir la valeur désirée pour le paramètre électrique considéré.

En d'autres termes, l'invention a également pour objet un procédé de réalisation d'un circuit intégré comprenant au moins un transistor à effet de champ à grille isolée, dans lequel on définit la géométrie de la zone active du transistor en utilisant un paramètre représentatif des contraintes mécaniques appliquées sur ladite zone active, compte tenu d'une valeur désirée d'au moins un paramètre électrique du transistor, ce paramètre électrique étant déterminé à partir d'un procédé de modélisation tel que défini ci-avant, en prenant en compte ledit paramètre de contrainte.

Ainsi on peut ajuster la géométrie de la zone active d'un transistor pour optimiser ce dernier en terme de mobilité par exemple, ce qui aura d'ailleurs pour conséquence de diminuer la résistance drain/source, ce qui est doublement bénéfique pour un transistor MOSFET.

Selon un mode de mise en oeuvre, on définit une zone active utile égale à une partie ou à la totalité de ladite zone active du transistor et le paramètre de contrainte est alors un paramètre géométrique $a_{eq}$ représentatif d'une distance, comptée dans le sens de la longueur du canal du transistor, séparant la grille du transistor du bord de la zone active utile.

Ainsi, lorsque le transistor est un transistor NMOS et que le paramètre géométrique $a_{eq}$ est supérieur à deux fois une distance minimale $a_{min}$ requise pour une prise de contact sur la zone active, on obtient une amélioration de la mobilité des porteurs notamment, par rapport à un transistor dont la longueur de la zone active est égale à ladite distance minimale requise.

De même, lorsque le circuit intégré comporte au moins un bloc comportant plusieurs transistors NMOS et que plus de 80% de ces transistors NMOS ont leur paramètre géométrique $a_{eq}$ supérieur à deux fois ladite distance minimale, on considère que l'ensemble du bloc de ce circuit intégré présente un avantage quant au critère de mobilité notamment.

Ces avantages ,sur la mobilité notamment, s'apprécient également lorsque le transistor est un transistor PMOS. Dans ce cas, le paramètre géométrique $a_{eq}$ est alors de préférence inférieur à deux fois ladite distance minimale requise.

De même, cet avantage, quant au critère de mobilité notamment, s'applique aussi par exemple à un circuit intégré comportant au moins un bloc comportant plusieurs transistors PMOS, et dont plus de 80% d'entre eux ont leur paramètre géométrique $a_{eq}$ inférieur à deux fois ladite distance minimale requise.

L'invention a également pour objet un circuit intégré comportant au moins un transistor à effet de champ à grille isolée.

Selon une caractéristique générale de l'invention, la zone active du transistor comporte une zone active utile égale à une partie ou à la totalité de ladite zone active du transistor, par le fait que la distance $a_{eq}$, comptée dans le sens de la longueur du canal du transistor, séparant la grille du transistor du bord de la zone active utile, est différente d'une distance minimale $a_{min}$ requise pour une prise de contact sur la zone active.

Selon un mode de réalisation, le transistor est un transistor NMOS, et par le fait que la distance $a_{eq}$ est supérieure à deux fois la distance minimale $a_{min}$.

Selon un autre mode de réalisation, le circuit intégré comporte au moins un bloc comportant plusieurs transistors NMOS, et par le fait que plus de 80% de ces transistors NMOS ont leur distance $a_{eq}$ supérieure à deux fois la distance minimale $a_{min}$.

Selon un autre mode de réalisation de l'invention, le transistor est un transistor PMOS, et par le fait que la distance $a_{eq}$ est inférieure à deux fois la distance minimale $a_{min}$.

Selon un mode de réalisation de l'invention, le circuit intégré comporte au moins un bloc comportant plusieurs transistors PMOS, et par le fait que plus de 80% de ces transistors PMOS ont leur distance $a_{eq}$ inférieure à deux fois la distance minimale $a_{min}$.

Quels que soient les modes de réalisation évoqués ci-dessus, la zone active utile peut être la partie de zone active contenue dans un rectangle dont la dimension latérale comptée dans le sens de la largeur du canal est égale à la largeur du canal, et dont chaque bord s'étendant dans le sens de la largeur du canal est séparé du flanc correspondant de la grille d'une distance limite prédéterminée, par exemple de l'ordre de dix fois la distance minimale requise $a_{min}$.

D'autres avantages et caractéristiques de l'invention apparaîtront à l'examen de la description détaillée de modes de réalisation et de mises en oeuvre, nullement limitatifs, et des dessins annexés sur lesquels :

- la figure 1 illustre d'une façon générale et très schématiquement un dispositif de modélisation selon l'invention, permettant une mise en oeuvre du procédé de modélisation selon l'invention ;
- la figure 2 est une représentation schématique d'un transistor MOS, mettant en évidence un paramètre géométrique selon l'invention ;
- la figure 3 illustre schématiquement deux courbes illustrant les avantages de l'invention sur le plan de la mobilité des porteurs d'un transistor ;
- les figures 4a à 4c illustrent schématiquement une élaboration d'un paramètre géométrique représentatif des contraintes appliquées sur la zone active d'un premier type de transistor MOS,
- les figures 5a, 5b et 6 et 7, illustrent schématiquement deux autres élaborations de paramètres géométriques représentatifs de contraintes appliquées sur les zones actives de deux autres types de transistor MOS ;

- la figure 8 illustre schématiquement la définition d'une zone active utile au sein d'un zone active d'un transistor MOS ;
- la figure 9 illustre schématiquement deux autres courbes illustrant une relation entre la mobilité de porteurs et le paramètre géométrique représentatif des contraintes ;
- la figure 10 illustre schématiquement et plus en détail des moyens du dispositif de modélisation permettant une détermination de la pente des courbes illustrée sur la figure 9 ;
- la figure 11 illustre schématiquement un organigramme général d'un mode de mise en oeuvre d'un procédé de réalisation d'un transistor MOS selon l'invention ; et

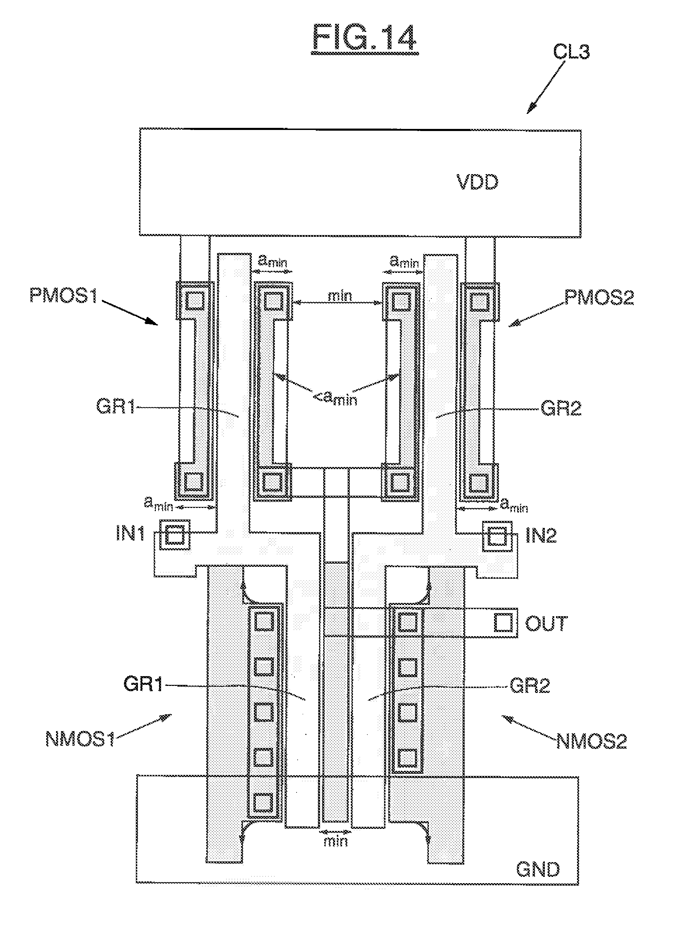

- les figures 12 à 14 illustrent schématiquement trois configurations géométriques différentes d'une cellule de base d'un circuit intégré, permettant d'obtenir des mobilités différentes.

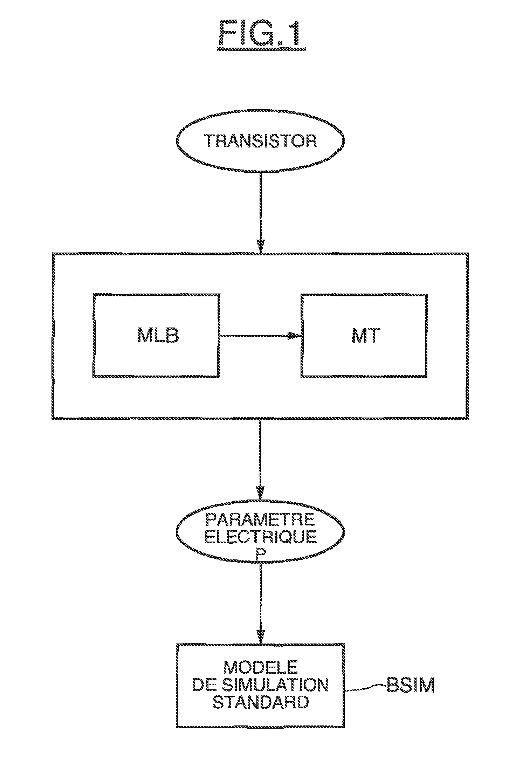

Sur la figure 1, la référence MLB désigne des moyens d'élaboration capables, à partir du schéma de placement (layout) d'un transistor, d'élaborer un paramètre de contrainte, représentatif des contraintes mécaniques appliquées sur la zone active du transistor. Matériellement, ces moyens d'élaboration peuvent consister en un extracteur connu en soi qui, à partir des schémas de placement, extrait des paramètres dimensionnels du transistor, comme par exemple la longueur et la largeur du canal, ainsi que des informations sur la connectique.

Une fois ce paramètre de contrainte déterminé, et sur lequel on fournira plus de détails ci-après, des moyens de traitement MT, par exemple réalisés de façon logicielle au sein d'un microprocesseur, vont déterminer certains au moins des paramètres électriques du transistor P, en tenant compte de ce paramètre de contrainte.

Le paramètre électrique P peut être par exemple la mobilité $\mu 0$ des porteurs à faible champ et à température ambiante, la tension de seuil Vth0 à tension grille/source nulle et pour une grande longueur de canal, ou encore la résistance parasite source/drain Rdsw par unité de largeur du canal.

Ces paramètres électriques P qui tiennent compte des contraintes appliquées sur la zone active du transistor, peuvent être ensuite injectés dans un modèle de simulation standard BSIM, tel que le modèle BSIM3v3.2 de l'Université de Berkeley, précité. Ce modèle permettra alors le calcul d'autres paramètres plus élaborés, tels que la mobilité effective $\mu_{eff}$, la résistance drain/source Rds, et la tension de seuil Vth. Cependant, à la sortie du modèle BSIM, ces paramètres tiendront également compte des contraintes appliquées sur la zone active du transistor.

Il a été observé qu'il était possible de prendre en compte l'ensemble des contraintes tridimensionnelles appliquées sur la zone active, en utilisant un paramètre de contrainte qui soit en fait un paramètre unidimensionnel, et, plus précisément, un paramètre géométrique $a_{eq}$ représentatif d'une distance, comptée dans le sens de la longueur du canal du transistor, séparant la grille du transistor du bord de la zone active.

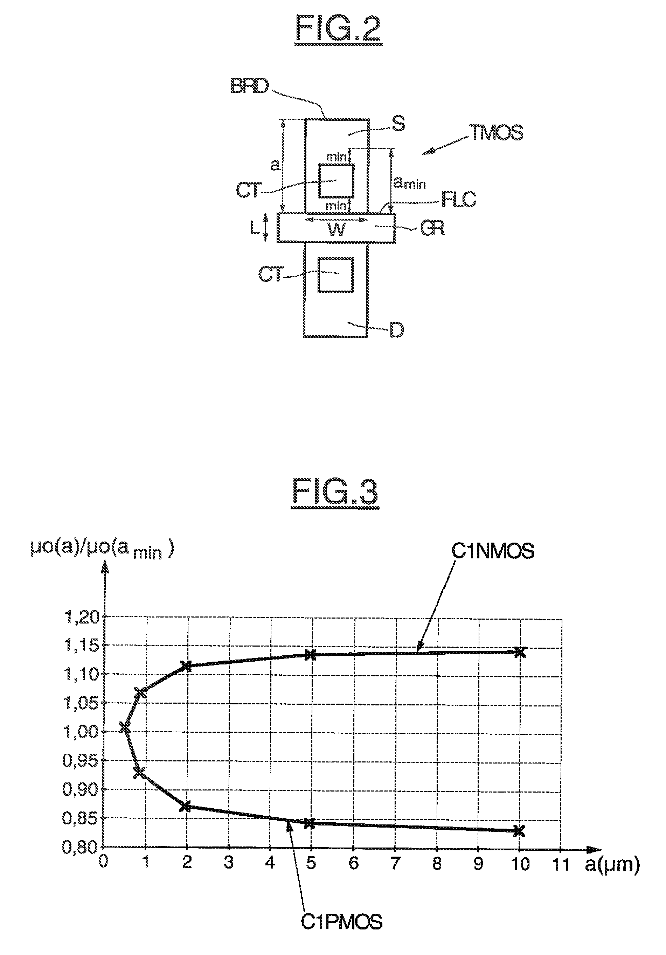

Lorsque, comme illustré sur la figure 2, la zone active du transistor PMOS est rectangulaire et la grille GR centrée sur la zone active de façon à définir des régions de source et de drain S et D, géométriquement identiques. Le paramètre de contrainte $a_{eq}$ est défini comme étant alors la distance $\underline{a}$ comptée dans le sens de la longueur L du canal, séparant un flanc FLC de la grille du bord correspondant BRD de la région de source ou de drain, ici de la région de source.

On notera ici que cette distance $\underline{a}$ peut être différente d'une distance minimale $a_{min}$ requise pour permettre la réalisation d'une prise de contact CT sur la région de source ou de drain.

La figure 3 illustre la variation en fonction de la distance $\underline{a}$, du rapport entre la mobilité $\mu 0$ pour la valeur $\underline{a}$ et la mobilité $\mu 0$ pour la valeur $a_{min}$. On observe que la mobilité $\mu 0$ augmente avec $\underline{a}$ pour un transistor NMOS (courbe C1NMOS) et diminue avec $\underline{a}$ pour un transistor PMOS (courbe C1PMOS). Par contre, pour un transistor PMOS, la mobilité augmenterait si $\underline{a}$ était inférieur à $a_{min}$.

Lorsque la zone active du transistor comporte des régions de source et de drain géométriquement différentes, on élabore un premier paramètre géométrique $a_s$ représentatif d'une première distance comptée dans le sens de la longueur du canal, séparant la grille du bord de la région de source.

On élabore par ailleurs un deuxième paramètre géométrique $a_d$ représentatif d'une distance comptée dans le sens de la longueur du canal, séparant la grille du bord de la région de drain. On élabore alors le paramètre de contrainte $a_{eq}$ comme étant défini par la formule (I) :

$$a_{eq} = 1/(1/2a_s + 1/2a_d) \qquad (I).$$

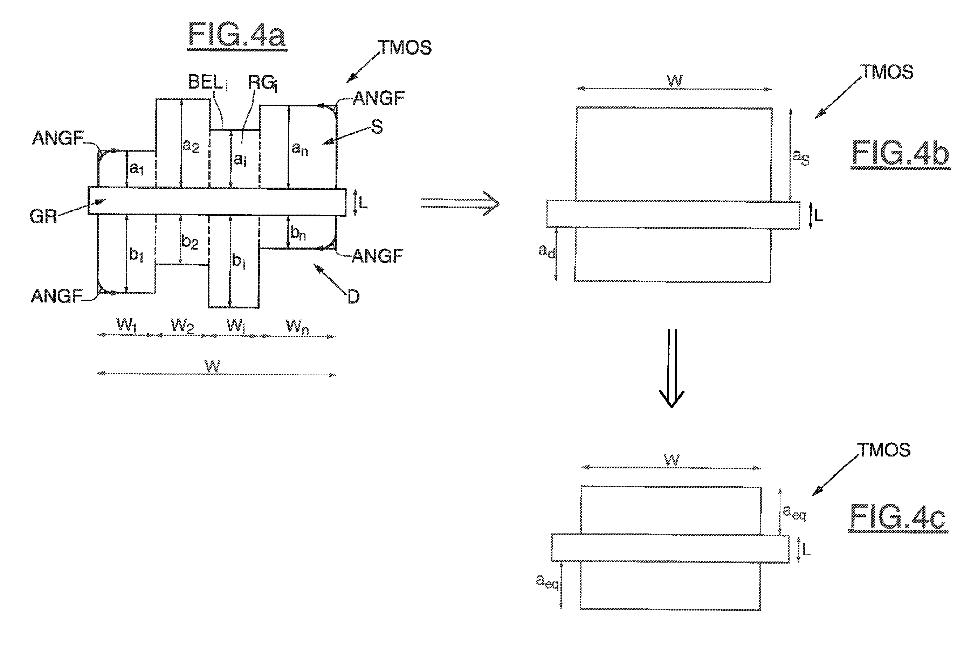

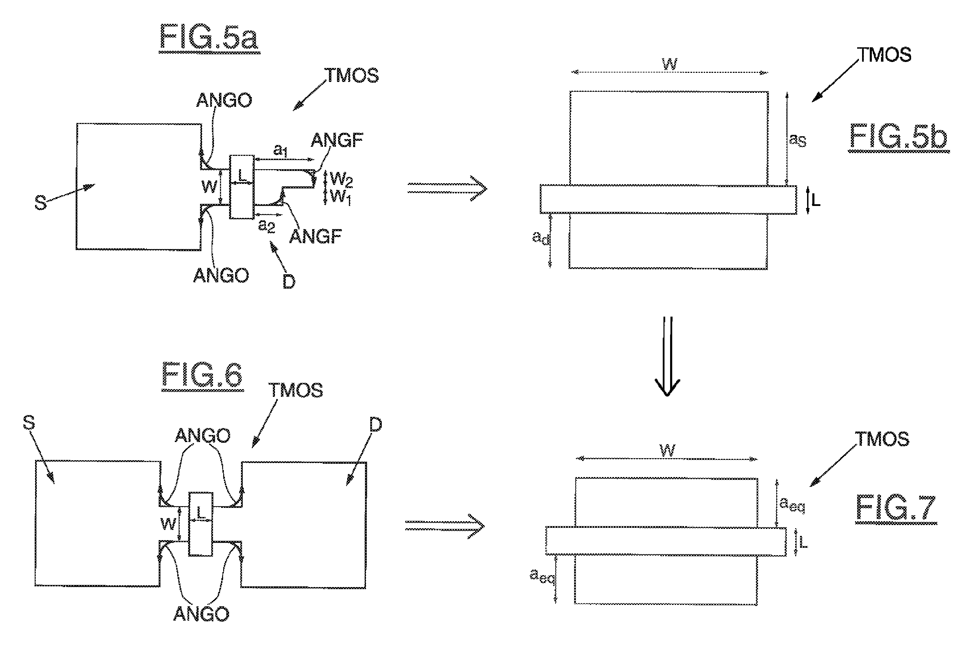

Par ailleurs, non seulement les régions de source et de drain peuvent être géométriquement différentes, mais elles peuvent être également irrégulières, comme c'est le cas sur la figure 4a ou sur les figures 5a et 6.

Parmi les zones de source ou de drain géométriquement irrégulières, on distingue celles présentant des angles fermés ANGF, comme illustré sur la figure 4a et sur la droite de la figure 5a, de celles présentant des angles ouverts ANGO, comme illustré sur la gauche de la figure 5a et sur la figure 6.

On se réfère maintenant plus particulièrement à la figure 4a, qui illustre une région de source S et de drain D, dont chaque côté latéral est exempt d'angle ouvert et définit avec le bord perpendiculaire de la zone considérée un angle fermé ANGF, ici un angle égal à 90°.

On décompose alors la région de source S en n régions élémentaires $RG_i$ (n=4 ici). Chaque région élémentaire $RG_i$ a une largeur élémentaire $W_i$ et un bord élémentaire $BEL_i$ séparé de la grille GR d'une distance élémentaire $a_i$ comptée dans le sens de la longueur L du canal.

Le paramètre géométrique $a_s$ est alors défini par la formule (II) ci-dessous :

$$a_s = W/(\sum_{i=1}^{n} W_i / a_i) \qquad (II)$$

dans laquelle W désigne la longueur totale du canal.

De même, on décompose la région de drain D en quatre régions élémentaires ayant la largeur élémentaire $W_i$ et dont le bord extrême est séparé du flanc correspondant de la grille GR par une distance élémentaire $b_i$.

Le paramètre géométrique $a_d$ est alors défini par la formule (III) ci-dessous :

$$a_d = W/(\sum_{i=1}^{n} W_i / b_i) \qquad (III)$$

En ce qui concerne la modélisation, le transistor TMOS de la figure 4a est alors équivalent au transistor TMOS de la figure 4b.

Par ailleurs, le paramètre de contrainte $a_{eq}$ est alors défini par la formule (I) ci-dessus. Et, du point de vue modélisation, le transistor TMOS de la figure 4a est alors équivalent au transistor TMOS de la figure 4c ayant une zone active régulière et rectangulaire avec une grille GR centrée.

Il convient d'ores et déjà de remarquer que, cette fois-ci, le paramètre $a_{eq}$ peut être très bien supérieur au paramètre $a_{min}$ ou bien inférieur au paramètre $a_{min}$.

On se réfère maintenant plus particulièrement aux figures 5a à 7, pour décrire le cas des surfaces de source ou de drain irrégulières présentant des angles ouverts ANGO.

Comme illustré sur la figure 5a et sur la figure 6, la présence d'un angle ouvert ANGO au niveau d'un bord latéral de la zone considérée (ici un angle de 270°) se traduit par une extension latérale de la région considérée vers l'extérieur du canal.

Pour une telle région de source ou de drain, le paramètre géométrique correspondant $a_s$ ou $a_d$ est alors pris égal à l'infini.

Le transistor TMOS géométriquement équivalent du point de vue modélisation au transistor TMOS de la figure 5a, est celui illustré sur la figure 5b avec le paramètre $a_s$ égal à l'infini et le paramètre $a_d$ défini par la formule (III) ci-dessus.

Et, le transistor TMOS finalement équivalent du point de vue modélisation au transistor 5a est le transistor TMOS de la figure 7 dans lequel $a_{eq}$ est toujours défini par la formule (I) ci-dessus, mais est, dans le cas présent, égal à $2a_d$, puisque $a_s$ est égal à l'infini.

Sur la figure 6, les deux régions de source et de drain présentent des angles ouverts ANGO. En conséquence, les deux paramètres $a_s$ et $a_d$ sont égaux à l'infini et le paramètre $a_{eq}$ du transistor TMOS équivalent (figure 7) est, en théorie, toujours défini par la formule (I) ci-dessus et est en pratique égal à l'infini puisque $a_s$ et $a_d$ sont eux-mêmes égaux à l'infini.

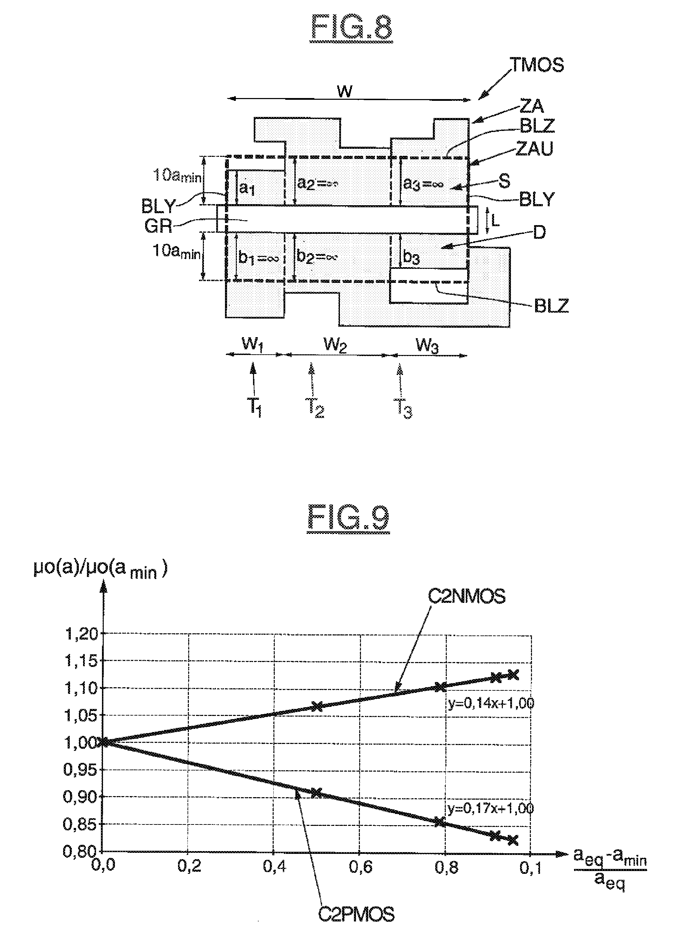

Lorsque la zone active ZA d'un transistor TMOS est particulièrement complexe, comme c'est le cas par exemple sur la figure 8, il est alors préférable de définir à l'intérieur de la zone active du transistor une zone active dite « utile » ZAU, qui est contenue dans un rectangle dont chacun des bords BLZ s'étendant dans le sens de la largeur W et du canal, est séparé du flanc correspondant de la grille d'une distance limite prédéterminée prise égale ici à $10a_{min}$.

Par ailleurs, la dimension latérale de ce rectangle comptée toujours dans le sens de la largeur du canal, c'est-à-dire en fait la longueur des bords BLZ (distance séparant les bords latéraux BLY), est égale à la largeur W du canal.

La valeur $10a_{min}$ est ici un bon compromis entre le gain en mobilité, par exemple, que l'on peut espérer obtenir, et la simplicité de la modélisation. En effet, au-delà de cette valeur $10a_{min}$, le gain en mobilité est très faible, comme illustré sur la courbe C1NMOS de la figure 3.

Ayant défini cette zone active utile ZAU, on procède alors, comme indiqué précédemment, en décomposant éventuellement les régions de source et de drain en n régions élémentaires (ici trois régions élémentaires), définissant trois transistors élémentaires $T_1$, $T_2$, $T_3$.

Par ailleurs, on considère alors qu'une distance élémentaire $a_i$ ou $b_i$ est égale à l'infini lorsqu'elle est égale à

ladite distance limite $10a_{min}$.

On procède ensuite, pour la détermination des paramètres $a_s$ et $a_d$ du transistor TMOS limitée à la zone active utile, comme indiqué précédemment.

Ainsi, le paramètre $a_s$, défini par la formule (II) ci-dessus, est en fait sensiblement défini par la formule (IV) ci-dessous :

$$a_s = W/(W_1/a_1) \qquad (IV)$$

puisque les distances $a_2$ et $a_3$ sont égales à l'infini.

De même, le paramètre $a_d$ est alors simplement défini par la formule (V) ci-dessous :

$$a_d = W/(W_3/b_3) \qquad (V)$$

puisque les distances $b_1$ et $b_2$ sont égales à l'infini.

Le paramètre équivalent $a_{eq}$ est toujours défini par la formule (I) ci-dessus.

Une fois le paramètre géométrique $a_{eq}$ élaboré, les moyens de traitement vont déterminer le paramètre électrique considéré du transistor P.

Dans ce mode de mise en oeuvre, le paramètre électrique P est défini par la formule (VI) ci-dessous :

$$P = P_{a\ min} (1 + CP_{L,W} (1 - a_{min}/a_{eq})) \qquad (VI)$$

dans laquelle $P_{a\ min}$ désigne la valeur du paramètre électrique P déterminée pour la distance minimale requise $a_{min}$ de la zone active, et $CP_{L,W}$ désigne un coefficient associé au paramètre électrique P et dépendant de la largeur W et de la longueur L du canal du transistor.

Cette relation est illustrée dans le cas particulier de la mobilité $\mu 0$ sur la figure 9. La courbe C2NMOS, qui est en fait une droite, illustre cette relation pour un transistor NMOS, tandis que la droite C2PMOS illustre cette relation pour un transistor PMOS.

Le coefficient $CP_{L,W}$ apparaît donc comme étant la pente d'une telle droite.

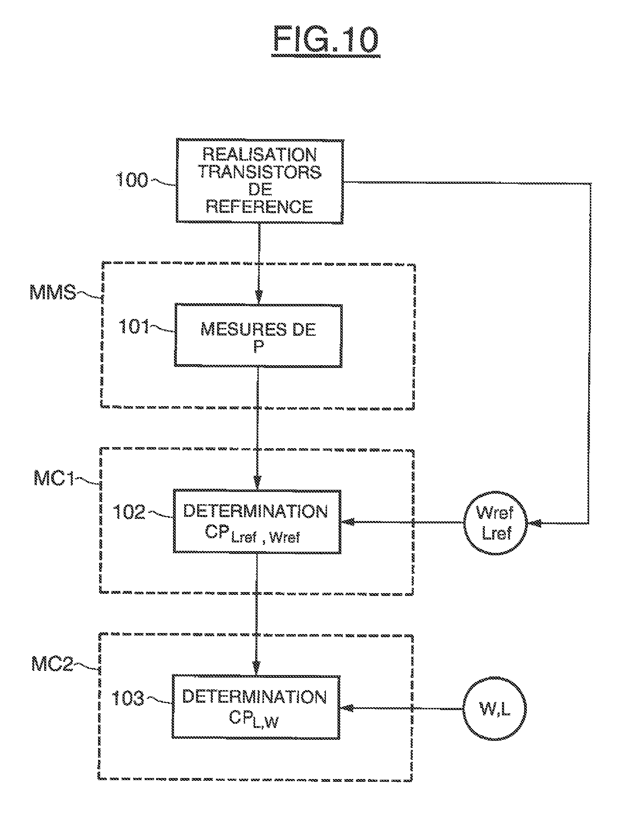

Pour déterminer ce coefficient $CP_{L,W}$, associé au paramètre P, on procède avantageusement comme illustré sur la figure 10.

On réalise (étape 100) plusieurs transistors de tests ou de références, ayant différentes valeurs de références $W_{ref}$, $L_{ref}$ pour la largeur et la longueur du canal, et différentes valeurs pour le paramètre de contrainte $a_{eq}$.

Puis, on mesure (étape 101) à l'aide de moyens de mesure MMS, de structure classique et connue en soi, pour chaque transistor de référence réalisé, la valeur du paramètre électrique considéré P. A titre indicatif, la mesure d'une mobilité ou d'une tension de seuil sur un transistor de référence peut s'effectuer par la méthode de Hammer, bien connue de l'homme de métier.

Puis, des premiers moyens de calcul MO1 déterminent (étape 102) pour chaque couple de valeurs $W_{ref}$ et $L_{ref}$, un coefficient de référence $CP_{Lref,Wref}$ comme étant la pente de la droite d'équation

$$Y = 1 + CP_{Lref,Wref} X ,$$

dans laquelle :

$$Y = P/P_{a\ min} ,$$

et

$$X = 1 - a_{min}/a_{eq}$$

Enfin, des deuxièmes moyens de calcul MC2 déterminent (étape 103) le coefficient $CP_{L,W}$, à partir des différents coefficients de référence $CP_{Lref}$, $W_{ref}$, compte tenu de la largeur W et de la longueur L du canal du transistor, en utilisant éventuellement une interpolation.

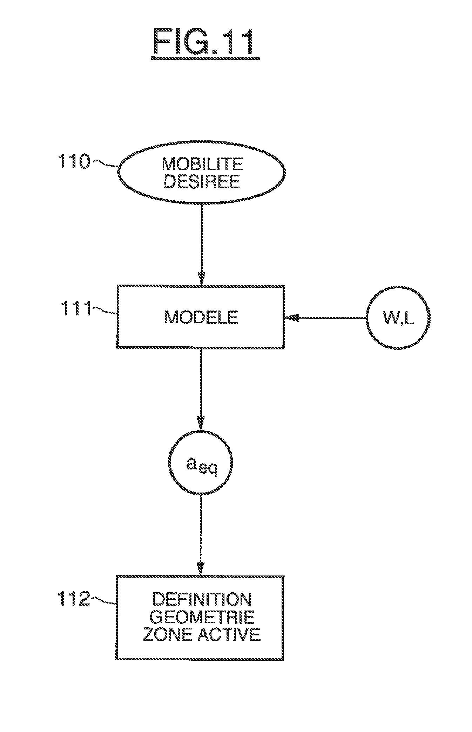

L'invention permet également la réalisation de circuits intégrés comportant les transistors MOS, dans lesquels on peut ajuster la géométrie de la zone active de ces transistors en fonction d'une valeur désirée d'un paramètre électrique du transistor, par exemple la mobilité (figure 11).

Dans ce cas, comme illustré sur cette figure 11, pour une mobilité désirée (étape 110) et pour une largeur et une longueur de canal choisies pour le transistor, l'application (étape 111) du modèle de simulation selon l'invention évoquée ci-avant, permet de délivrer la valeur du paramètre de contrainte $a_{eq}$. On peut alors définir la géométrie de la zone active du transistor (étape 112).

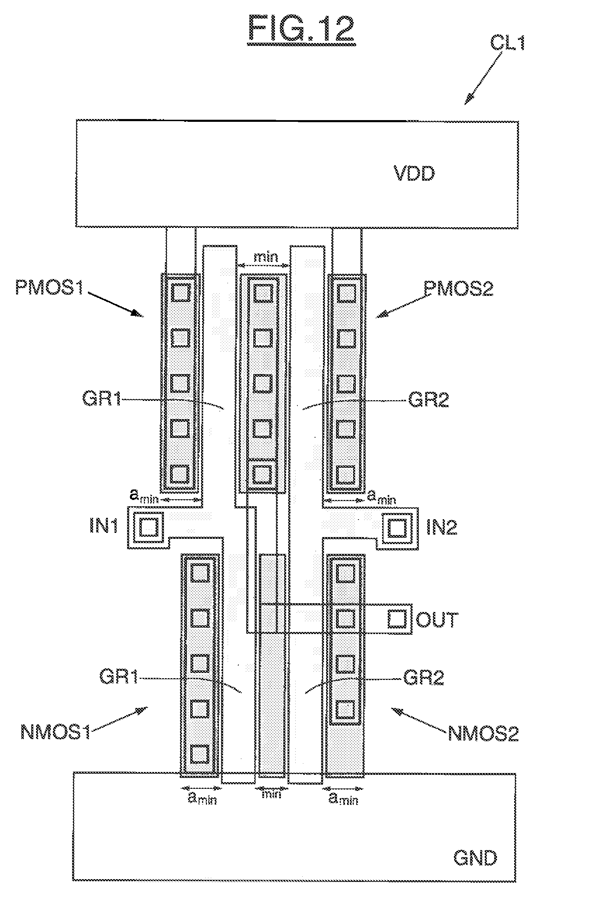

Ainsi, la figure 12 illustre très schématiquement le schéma de placement (layout) d'une cellule de base CL1 du type porte NAND et à deux entrées (porte NAND2).

Cette cellule comporte, de façon classique, deux transistors PMOS, référencés PMOS1 et PMOS2, et deux transistors NMOS, référencés NMOS1 et NMOS2. La première entrée IN1 de cette cellule CL1 est prise sur les grilles GR1 des deux transistors PMOS1 et NMOS1, tandis que la deuxième entrée IN2 de la cellule est prise sur les grilles GR2 des deux transistors PMOS2 et NMOS2. La sortie OUT de la cellule CL1 est prise sur la région de source commune des transistors PMOS1 et PMOS2.

On voit sur cette figure 12, que les longueurs respectives des zones de source et de drain des transistors (longueur comptée dans le sens de la longueur du canal) ont été prises égales à la distance minimale $a_{min}$. De même, l'espacement entre les grilles a été également pris à une valeur minimale min.

En conséquence, une telle cellule a été réalisée en utilisant un critère de haute densité.

Par contre, en ce qui concerne les transistors PMOS, le paramètre de contrainte $a_{eq}$ est supérieur au paramètre $a_{min}$ et inférieur à deux fois ce paramètre.

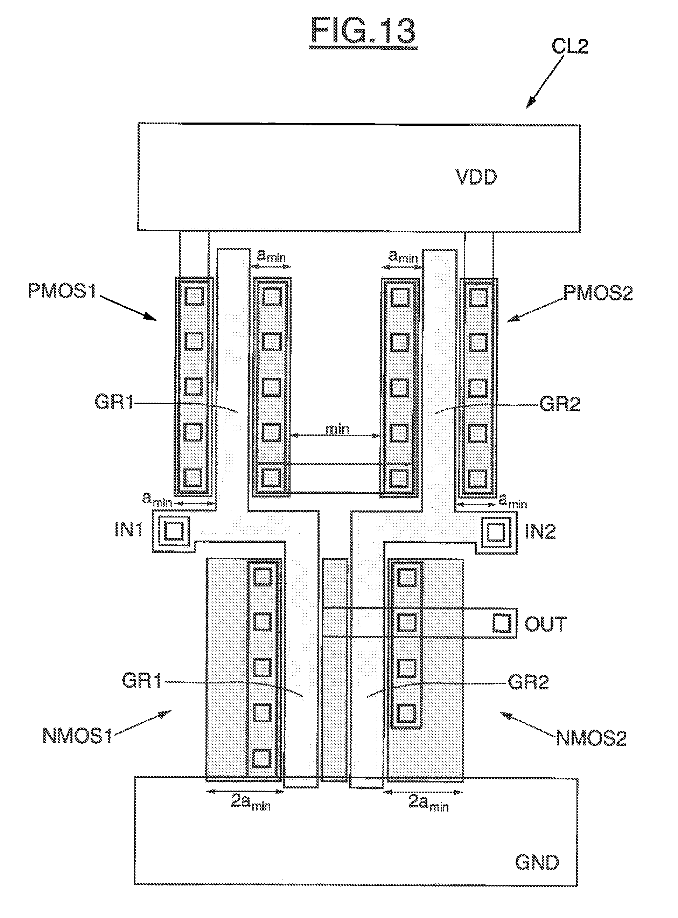

Il en en est de même pour les transistors NMOS. Une telle cellule CL1 n'a pas été, par conséquent, optimisée en terme de mobilité notamment, par rapport à une cellule CL2 du même type, telle qu'illustrée sur la figure 13.

Sur cette figure 13, on voit que les régions de source des transistors PMOS1 et PMOS2 sont séparées de la distance min. Par ailleurs, la longueur de ces régions de source et de drain a été choisie égale à la valeur $a_{min}$. En conséquence, le paramètre de contrainte $a_{eq}$ pour ces deux transistors PMOS est égal à $a_{min}$.

De même, les régions de source des transistors NMOS ont été élargies à la valeur $2a_{min}$. En conséquence, le paramètre de contrainte $a_{eq}$ pour les deux transistors NMOS est cette fois-ci supérieur à deux fois la distance minimale requise $a_{min}$.

Cette cellule CL2 présente donc une mobilité plus grande que celle de la cellule CL1.

La cellule CL3, également du type NAND2, présente une mobilité encore accrue. En effet, les zones actives des transistors PMOS1 et PMOS2 présentent un rétrécissement entre les prises de contact, la largeur de ce rétrécissement étant inférieure à la distance $a_{min}$.

En conséquence, le paramètre de contrainte $a_{eq}$ pour ces deux transistors PMOS est cette fois-ci inférieur à la distance minimale requise $a_{min}$.

Par ailleurs, les zones actives des transistors NMOS présentent des angles ouverts, ce qui confère au paramètre $a_{eq}$ la valeur infinie.

L'invention n'est pas limitée aux modes de mise en oeuvre et de réalisation qui viennent d'être décrits mais en embrasse toutes les variantes.

Plus précisément, la détermination du paramètre P a été décrite en utilisant une valeur de référence $P_{amin}$ qui est la valeur de ce paramètre pour la valeur de référence $a_{min}$. Cependant on pourrait également utiliser une autre valeur de référence, par exemple la valeur de ce paramètre pour une autre distance de référence que $a_{min}$, et ce sans modifier les principes généraux et les avantages de l'invention.

Par ailleurs la détermination du paramètre électrique P n'est pas limitée à la formule (VI) mentionnée ci-avant.

En effet d'autres formules faisant également intervenir la valeur du paramètre P pour la distance de référence ainsi que le coefficient dépendant de la largeur et de la longueur du canal, seraient envisageables pour certains paramètres particuliers comme la tension de seuil.

Ainsi, pour le calcul de la tension de seuil on pourrait utiliser par exemple une formule du type $P = P_{amin} + CP2_{L,W}(1-amin/aeq)$, dans laquelle $CP2_{L,W}$ résulte du produit de deux constantes $P_{amin}$ et $CP_{L,W}$.

Et dans ce cas, la correction de la tension de seuil Vth dans le modèle BSIM3v3.2 par exemple, ne fait intervenir que la correction du paramètre Vth0 ( tension de seuil à tension grille/source nulle et pour une grande largeur de canal), alors que l'utilisation d'une correction multiplicatrice définie par la formule (VI) nécessiterait la correction préalables des paramètres Vth0, K1, K2, K3, K3b, Dvt0, Dvt0w, Eta0, Etab.

**Revendications**

**1.** Procédé de modélisation d'un circuit intégré comportant au moins un transistor à effet de champ à grille isolée, **caractérisé par le fait qu'**on élabore un paramètre ($a_{eq}$) représentatif des contraintes mécaniques appliquées sur la zone active du transistor, et on prend en compte ce paramètre de contrainte pour la détermination de certains au moins des paramètres électriques (P) du transistor.

**2.** Procédé selon la revendication 1, **caractérisé par le fait qu'**on élabore le paramètre de contrainte ($a_{eq}$) à partir d'au moins un paramètre géométrique unidimensionnel.

**3.** Procédé selon la revendication 1 ou 2, **caractérisé par le fait qu'**on définit à partir de la zone active (ZA) du transistor, une zone active utile (ZAU) égale à une partie ou à la totalité de ladite zone active, et **par le fait que** le paramètre de contrainte ($a_{eq}$) comprend un paramètre géométrique représentatif d'une distance, comptée dans le sens de la longueur du canal du transistor, séparant la grille du transistor du bord de la zone active utile.

**4.** Procédé selon l'une des revendications précédentes, **caractérisé par le fait que** la détermination d'un paramètre électrique considéré (P) du transistor est effectuée à partir d'une relation faisant intervenir

- la valeur de ce paramètre électrique déterminée pour une distance de référence, par exemple une distance minimale requise de la zone active,
- la valeur du paramètre de contrainte du transistor,
- la valeur de ladite distance de référence, par exemple la distance minimale requise, et
- un coefficient associé audit paramètre électrique et dépendant de la largeur et de la longueur du canal du transistor.

**5.** Procédé selon l'une des revendications précédentes, **caractérisé par le fait que** les paramètres électriques comportent la mobilité des porteurs à faible champ et à température ambiante, la tension de seuil, la résistance drain/source.

**6.** Procédé selon l'une des revendications précédentes, **caractérisé par le fait qu'**on injecte les paramètres électriques déterminés en tenant compte du paramètre de contrainte, dans un modèle standard de transistor (BSIM).

**7.** Dispositif de modélisation d'un circuit intégré comportant au moins un transistor à effet de champ à grille isolée, **caractérisé par le fait qu'**il comprend des moyens d'élaboration (MLB) aptes à élaborer un paramètre représentatif des contraintes mécaniques appliquées sur la zone active du transistor, et des moyens de traitement (MT) aptes à déterminer certains au moins des paramètres électriques (P) du transistor en prenant en compte ce paramètre de contrainte.

**8.** Dispositif selon la revendication 7, **caractérisé par le fait que** le paramètre de contrainte ($a_{eq}$) comprend au moins un paramètre géométrique unidimensionnel.

**9.** Dispositif selon la revendication 7 ou 8, **caractérisé par le fait que** les moyens d'élaboration (MLB) sont aptes à définir à partir de la zone active du transistor, une zone active utile égale à une partie ou à la totalité de ladite zone active, et **par le fait que** le paramètre de contrainte ($a_{eq}$) comprend un paramètre géométrique représentatif d'une distance, comptée dans le sens de la longueur du canal du transistor, séparant la grille du transistor du bord de la zone active utile.

**10.** Dispositif selon l'une des revendications 7 à 9, **caractérisé par le fait que** les moyens de traitement (MT) déterminent un paramètre électrique considéré du transistor à partir d'une relation faisant intervenir

- la valeur de ce paramètre électrique déterminée pour une distance de référence, par exemple une distance minimale requise de la zone active,
- la valeur du paramètre de contrainte du transistor,
- la valeur de ladite distance de référence, par exemple la distance minimale requise, et
- un coefficient associé audit paramètre électrique et dépendant de la largeur et de la longueur du canal du transistor.

**11.** Dispositif selon l'une des revendications 7 à 10, **caractérisé par le fait que** les paramètres électriques comportent la mobilité des porteurs à faible champ et à température ambiante, la tension de seuil, la résistance drain/source.

**12.** Dispositif selon l'une des revendications 7 à 11, **caractérisé par le fait que** les moyens de traitement (MT) sont aptes à calculer les paramètres électriques en tenant compte du paramètre de contrainte et d'un modèle standard de transistor (BSIM).

**13.** Procédé de réalisation d'un circuit intégré comprenant au moins transistor à effet de champ à grille isolée, **caractérisé par le fait qu'**on définit la géométrie de la zone active du transistor en utilisant un paramètre représentatif des contraintes mécaniques appliquées sur ladite zone active, compte tenu d'une valeur désirée d'au moins un paramètre électrique du transistor déterminé à partir d'un procédé de modélisation selon l'une des revendications 1 à 6 en prenant en compte ledit paramètre de contrainte($a_{eq}$).

**14.** Procédé selon la revendication 13, **caractérisé par le fait que** le paramètre de contrainte ($a_{eq}$) comprend au moins un paramètre géométrique unidimensionnel.

**15.** Procédé selon la revendication 14, **caractérisé par le fait qu'**on définit une zone active utile égale à une partie ou à la totalité de ladite zone active du transistor, et **par le fait que** le paramètre de contrainte ($a_{eq}$) comprend un paramètre géométrique représentatif d'une distance, comptée dans le sens de la longueur du canal du transistor, séparant la grille du transistor du bord de la zone active utile.

**16.** Procédé selon l'une des revendications 13 à 15, **caractérisé par le fait que** les paramètres électriques comportent la mobilité des porteurs à faible champ, la tension de seuil, la résistance drain/source.

**17.** Procédé selon la revendication 15 ou 16, **caractérisé par le fait que** le transistor est un transistor NMOS, et **par le fait que** ledit paramètre géométrique ($a_{eq}$) est supérieur à deux fois une distance minimale ($a_{min}$) requise pour une prise de contact sur la zone active.

**18.** Procédé selon la revendication 15 ou 16, **caractérisé par le fait que** le transistor est un transistor PMOS, et **par le fait que** ledit paramètre géométrique ($a_{eq}$) est inférieur à deux fois une distance minimale $a_{min}$ requise pour une prise de contact sur la zone active.

**19.** Circuit intégré comportant au moins un transistor à effet de champ à grille isolée, **caractérisé par le fait que** la zone active du transistor comporte une zone active utile égale à une partie ou à la totalité de ladite zone active du transistor, **par le fait que** la distance ($a_{eq}$) comptée dans le sens de la longueur du canal du transistor, séparant la grille du transistor du bord de la zone active utile, est différente d'une distance minimale ($a_{min}$) requise pour une prise de contact sur la zone active.

**20.** Circuit intégré selon la revendication 19, **caractérisé par le fait que** le transistor est un transistor NMOS, et **par le fait que** la distance ($a_{eq}$) comptée dans le sens de la longueur du canal du transistor, séparant la grille du transistor du bord de la zone active utile est supérieure à deux fois ladite distance minimale ($a_{min}$).

**21.** Circuit intégré selon la revendication 19, **caractérisé par le fait que** le transistor est un transistor PMOS, et **par le fait que** la distance ($a_{eq}$) comptée dans le sens de la longueur du canal du transistor, séparant la grille du transistor du bord de la zone active utile est inférieure à deux fois ladite distance minimale ($a_{min}$).

**22.** Circuit intégré selon l'une des revendications 19 à 21, **caractérisé par le fait que** ladite zone active utile est la partie de zone active contenue dans un rectangle dont la dimension latérale comptée dans le sens de la largeur du canal, est égale à la largeur du canal, et dont chaque bord s'étendant dans le sens de la largeur du canal est séparé du flanc correspondant de la grille d'une distance limite prédéterminée.

## FIG.1

TRANSISTOR

MLB → MT

PARAMETRE
ELECTRIQUE
P

MODELE
DE SIMULATION —— BSIM
STANDARD

# FIG.2

# FIG.3

## FIG.4a

## FIG.4b

## FIG.4c

## FIG.5a

## FIG.5b

## FIG.6

## FIG.7

EP 2 363 818 A2

## FIG.8

## FIG.9

# FIG.10

100 — REALISATION TRANSISTORS DE REFERENCE

MMS

101 — MESURES DE P

MC1

102 — DETERMINATION $CP_{Lref, Wref}$

Wref Lref

MC2

103 — DETERMINATION $CP_{L,W}$

W,L

# FIG.11

110 — MOBILITE DESIREE

111 — MODELE ← W,L

$a_{eq}$

112 — DEFINITION GEOMETRIE ZONE ACTIVE

# FIG.12

CL1

VDD

PMOS1

PMOS2

GR1

GR2

min

$a_{min}$

$a_{min}$

IN1

IN2

OUT

GR1

GR2

NMOS1

NMOS2

$a_{min}$   min   $a_{min}$

GND

# FIG.13

CL2

VDD

PMOS1

$a_{min}$    $a_{min}$

GR1

min

GR2

$a_{min}$    $a_{min}$

IN1    IN2

OUT

GR1    GR2

NMOS1    NMOS2

$2a_{min}$    $2a_{min}$

GND

PMOS2

## FIG.14